# EUROPÄISCHE PATENTSCHRIFT

(11) **EP 4 545 986 B1**
(45) Veröffentlichungstag und Bekanntmachung des Hinweises auf die Patenterteilung: **04.03.2026**
(21) Anmeldenummer: 23205350.4
(22) Anmeldetag: 23.10.2023
(51) Int. Cl.: G01R 31/34, G01R 31/58, F24F 11/30, G01R 31/52, G01R 31/54, G01R 31/42

(54) **VERFAHREN ZUM ÜBERPRÜFEN DER BETRIEBSBEREITSCHAFT DER ELEKTRISCHEN ZULEITUNGEN ZU EINEM DREHSTROMMOTOR UND DES DREHSTROMMOTORS SELBST IN EINEM RUHEZUSTAND**
METHOD FOR CHECKING THE OPERATIONAL READINESS OF THE ELECTRIC SUPPLY LINES TO A THREE-PHASE MOTOR AND THE THREE-PHASE MOTOR EVEN IN A STANDBY STATE
PROCÉDÉ POUR VÉRIFIER L'ÉTAT DE FONCTIONNEMENT DES LIGNES D'ALIMENTATION ÉLECTRIQUES D'UN MOTEUR TRIPHASÉ ET DU MOTEUR TRIPHASÉ EN MODE VEILLE

(43) Veröffentlichungstag der Anmeldung: 30.04.2025
(73) Patentinhaber: D+H Mechatronic AG, 22949 Ammersbek (DE)
(72) Erfinder: Kern, Julian, 22889 Tangstedt (DE)
(74) Vertreter: Raffay & Fleck

(56) Entgegenhaltungen:
- WO-A2-2016/033576
- DE-A1- 102009 000 659
- US-A1- 2011 037 495
- US-A1- 2020 049 769

## Beschreibung

Die vorliegende Erfindung betrifft die Überprüfung und potentielle Überwachung der Betriebsbereitschaft eines an eine Steuerschaltung angeschlossenen Drehstrommotors während eines nicht betriebenen Zustandes einschließlich insbesondere einer Prüfung der Betriebsbereitschaft der zu dem Drehstrommotor führenden elektrischen Zuleitungen.

Drehstrommotoren werden in der Technik eingesetzt, um mit hoher Leistungsaufnahme mechanische Bewegungen ausführen zu können. Während es Anwendungen gibt, in denen solche Drehstrommotoren mehr oder minder kontinuierlich betrieben werden, gibt es vielfach auch solche Konstellationen, in denen die verbauten und angeschlossenen Drehstrommotoren nur zeitweise zum Einsatz kommen, über gewisse Zeiträume hingegen abgeschaltet sind, dabei allerdings betriebsbereit stehen müssen. Hierbei gibt es auch solche Anwendungen, in denen ein Betrieb der Drehstrommotoren eine absolute Ausnahme darstellt, gleichwohl die permanente Betriebsbereitschaft der Drehstrommotoren selbst einerseits, aber vor allem auch der diesen mit einer Energiequelle und/oder einer Steuerung verbindenden Zuleitungen von höchster Wichtigkeit oder gar absolut sicherheitsrelevant ist.

So werden z.B. Brandgas- und Zuluftventilatoren sowie Antriebe für natürliche Rauch- und Wärmeabzugsgeräte, bei denen es sich um wichtige und gesetzlich geregelte Bestandteile in vielen Gebäuden handelt und die im Brandfall für die Ableitung von Brandgasen und für den Personen- und Gebäudeschutz sorgen, wegen der für die Förderung von Luft und die schnelle Abfuhr von Rauch und Brandgasen benötigen hohen Leistung mit Drehstrommotoren betrieben.

Diese Brandgas- und Zuluftventilatoren werden dabei für den Ernstfall vorgehalten, werden im regulären Gebäudebetrieb gerade nicht betätigt und betrieben. Um ungeachtet der langen Standzeiten, in denen diese Einrichtungen nicht betrieben werden, sicherzustellen, dass sie im Ernstfall auch funktionieren und die Drehstrommotoren bei Betätigung ordnungsgemäß anlaufen und die Ventilatoren in Rotation versetzen, werden bei solchen Systemen, wie auch bei anderen Sicherheitseinrichtungen für Gebäude, wie z.B. Alarmanlagen, Brandmeldeanlagen und eben den hier erwähnten Rauch- und Wärmeabzugsanlagen, die Leitungen von einer Steuerung zu Sensoren und/oder Aktoren auf Drahtbruch und Kurzschluss überprüft, um so einen etwaigen Fehlerfall zu erkennen und Maßnahmen einzuleiten. Eine solche Überprüfung zur Erhöhung der Betriebssicherheit ist baurechtlich auch zum Großteil vorgeschrieben.

Während es hinreichend bekannt ist, Drehstrommotoren und auch die diesen elektrisch speisenden Zuleitungen für die Phasen des Drehstroms im Betrieb zu überwachen und aus mittels unterschiedlicher Sensorik erfasster Daten auf einen ordnungsgemäßen Zustand des überwachten Motors und der diesen anschließenden elektrischen Leitungen rückzuschließen, stellt die zuverlässige Überprüfung oder sogar Überwachung von Drehstrommotoren und insbesondere deren elektrischen Anschlussleitungen in einem nicht betriebenen Zustand eine Herausforderung dar, die bisher nicht zufriedenstellend gelöst werden konnte. Gerade Sicherheitsanlagen in Gebäuden, aber nicht allein diese, befinden sich die meiste Zeit im Bereitschaftsbetrieb. Da herkömmliche Überprüfungs- bzw. Überwachungseinrichtungen in diesem Zustand dreiphasige Zuleitungen zu Drehstrommotoren nicht überprüfen oder gar überwachen, werden insbesondere in den elektrischen Zuleitungen vorhandene Fehler regelmäßig erst bei turnusgemäß in größeren Zeitabständen durchgeführten Funktionsüberprüfungen, bei denen die Systeme in Betrieb genommen, also betrieben werden, erkannt. Im schlimmsten Fall werden solche Fehler, wenn sie erst nach der zuletzt durchgeführten Funktionsüberprüfung aufgetreten sind, erst dann festgestellt, wenn die Systeme benötigt werden, dann aber aufgrund gerade nicht gegebener Betriebsbereitschaft insbesondere der elektrischen Zuleitungen ausfallen. Dies kann im schlimmsten Fall zu der Gefährdung von Menschenleben, jedenfalls aber zu Gesundheitsgefährdungen von Menschen führen, deren Leben und Gesundheit die Sicherheitsanlagen in einem solchen Ernstfall gerade schützen sollten.

Die Dokumente WO 2016/033576 A2, DE 10 2009 000659 A1, US 2020/049769 A1, US 2011/037495 A1 zeigen Test Verfahren der Verkabelung der Stromversorgung eines Drehstrommotors in einem nicht betriebenen Zustand der Stand der Technik.

Zwar ist in der DE 10 2022 001 334 A1 schon eine Vorgehensweise beschrieben, um Drehstrommotoren und deren Anschlüsse auch in einem nicht betriebenen Zustand zu überprüfen. Allerdings wird dabei nicht gesondert auf eine Prüfung auch der elektrischen Zuleitungen abgestellt und ist die dort offenbarte Vorgehensweise undifferenziert und kann insbesondere nicht spezifisch mögliche Fehlerursachen adressieren. Bei dem in diesem Stand der Technik offenbarten Verfahren wird eine Spannung zwischen zwei der drei Leiter der dreiphasigen Zuleitung angelegt, die dritte Phase bleibt unbeschaltet. Es wird dann ein Strom in dieser Schaltung eingestellt, der einem durch rechnerische Ableitung aus den Werten für Nennstrom und Nennspannung des Drehstrommotors bestimmten Sollstrom bei einer Sollspannung entspricht. Dann wird die Spannung in dem so erhaltenen Stromkreis gemessen und mit der errechneten Sollspannung vergleichen. Bei einer oberhalb einer Toleranzschwelle liegenden Abweichung der gemessenen Spannung von der Sollspannung wird ein Fehler festgestellt. Diese Vorgehensweise ist, wie schon erwähnt, undifferenziert und erlaubt keine klaren Rückschlüsse. Sie ist zudem fehleranfällig, wenn aufgrund gegenteilig wirksamer Effekte von in unterschiedlichen Elementen des Systems auftretenden Fehlern sich ein Ausgleich der zu erwartenden Abweichungen ergibt und so dann keine Unregelmäßigkeit bzw. kein Ausfall des getesteten Systems festgestellt werden kann.

Vor dem Hintergrund dieses Standes der Technik ist es Aufgabe der Erfindung, eine sichere und zuverlässige und dabei zugleich auch wirtschaftliche Vorgehensweise aufzuzeigen, wie bei einem Drehstrommotor überprüft werden kann, ob in einer Betriebsart "Bereitschaft", also in einem Zustand, in dem der Drehstrommotor nicht betrieben wird, eine dreiphasige Zuleitung, der elektrische Anschluss sowie die Induktionsspulen des Drehstrommotors, wie z.B. eines Antriebsmotors eines Zuluft- oder Brandgasventilators oder eines Antriebs eines natürlichen Rauch- und Wärmeabzugsgeräts in einem Gebäude, in einem ordnungsgemäßen und funktionstüchtigen Zustand sind, wobei insbesondere gerade auch die elektrischen Anschlussleitungen mit überprüft werden sollen.

Erfindungswesentlich betrifft dies also eine angestrebte Überprüfung, bzw. Überwachung, einer dreiphasigen Leitung von einer Steuerung zu einem Drehstrommotor, z.B. zu einem Drehstrommotor für den maschinellen und natürlichen Rauchabzug, im Bereitschaftsbetrieb, also bei stehendem Motor.

Die vorstehend bezeichnete Aufgabe wird erfindungsgemäß gelöst durch ein Verfahren zum Überprüfen der Betriebsbereitschaft eines an eine Steuerschaltung angeschlossenen Drehstrommotors nebst der diesen Drehstrommotor mit der Steuerschaltung verbindenden, dreiphasigen Zuleitungen (L1, L2, L3) in einem nicht betriebenen Zustand, wie es im Anspruch 1 bestimmt ist. Vorteilhafte Weiterbildungen des erfindungsgemäßen Verfahrens sind in den Ansprüchen 2 bis 5 bezeichnet.

In einem weiteren Aspekt wird mit der Erfindung eine Steuerschaltung für die Steuerung eines daran angeschlossenen Drehstrommotors vorgeschlagen, wobei die Steuerschaltung für die Durchführung eines hier beanspruchten Verfahrens eingerichtet ist. Weiterhin wird mit der Erfindung eine Entrauchungseinrichtung für ein Gebäude mit wenigstens einem durch einen Drehstrommotor angetriebenen Luftförderer angegeben, bei der zum Überprüfen oder auch Überwachen der Betriebsbereitschaft des angeschlossenen und nicht betriebenen Drehstrommotors ein hier offenbartes Verfahren zum Einsatz kommt.

Bei einem erfindungsgemäßen Verfahren zum Überprüfen der Betriebsbereitschaft eines an eine Steuerschaltung angeschlossenen Drehstrommotors nebst der diesen Drehstrommotor mit der Steuerschaltung verbindenden, dreiphasigen Zuleitungen (L1, L2, L3) in einem nicht betriebenen Zustand werden, anders als im Stand der Technik gemäß der DE 10 2022 001 334 A1, zwei verschiedene Prüfungsvorgänge unternommen. So wird nämlich in einem ersten Prüfungsvorgang für eine Prüfung hinsichtlich eines möglichen Kabelbruchs eine erste Stromquelle in Form einer Gleichstromquelle oder einer Wechselstromquelle niedriger Frequenz gleichzeitig oder nacheinander mit jeweils einem von zwei unterschiedlichen Paaren der Zuleitungen L1, L2, L3 verbunden.

Unter einem Wechselstrom niedriger Frequenz ist ein Wechselstrom zu verstehen, dessen Frequenz so niedrig gewählt ist, dass die Induktivität der Statorwicklung des Drehstrommotors in dem jeweils geschalteten Stromkreis für einen Wechselstrom dieser Frequenz keinen wesentlichen Blindwiderstand aufweist, insbesondere einen Blindwiderstand der um wenigstens eine Größenordnung niedriger liegt als der gesamte Leitungswiderstand der Zuleitung und der Leitungen in dem Drehstrommotor. Der in dem so geschalteten Stromkreis fließende Strom und/oder die dort anliegende Spannung wird (werden) gemessen und das oder die Messergebnis(se) wird oder werden als Indikator für einen ersten elektrischen Widerstand hergenommen. Dabei kann insbesondere auch der Widerstand aus den Messwerten der Stromstärke und der Spannung konkret ermittelt werden. Es kann hierbei auch ein vorgegebener Strom oder eine vorgegebene Spannung an der Gleichstromquelle oder der Wechselstromquelle mit niedriger Frequenz eingestellt und der eingestellte Wert für die Ermittlung des ersten Widerstandes unter Berücksichtigung des für die jeweils andere, nicht an der Stromquelle vorgegebenen Größe gemessenen Wertes hergenommen werden.

In einem zweiten Prüfungsvorgang wird für eine Prüfung hinsichtlich eines möglichen Kurzschlusses eine zweite Stromquelle in Form einer Wechselstromquelle hoher Frequenz gleichzeitig oder nacheinander mit jeweils einem Paar wenigstens jeweils zwei unterschiedlicher Paare der Zuleitungen L1, L2, L3 verbunden. Die Frequenz der zweiten Wechselstromquelle wird dabei so groß gewählt, dass ein Blindwiderstand der Induktivität der Statorwicklung des Drehstrommotors in dem jeweils geschalteten Stromkreis wesentlich höher ist als der Widerstand der zu überprüfenden, bzw. zu überwachenden Zuleitung. Der in dem so geschalteten Stromkreis fließende Strom und/oder die dort anliegende Spannung wird (werden) gemessen und das oder die Messergebnis(se) wird oder werden als Indikator für einen zweiten elektrischen Widerstand hergenommen. Dabei kann insbesondere auch der zweite Widerstand aus den bekannten (eingestellten) und/oder gemessenen Werten der Stromstärke und der Spannung konkret ermittelt werden. Es kann hierbei auch ein vorgegebener Strom oder eine vorgegebene Spannung an der Wechselstromquelle hoher Frequenz eingestellt und der eingestellte Wert für die Ermittlung des zweiten Widerstandes unter Berücksichtigung des für die jeweils andere, nicht an der Stromquelle vorgegebenen Größe gemessenen Wertes hergenommen werden.

Für die Bewertung der Betriebsbereitschaft des Drehstrommotors, also der Funktionalität von Motor und Zuleitungen, erfolgt ein Vergleich der ermittelten Messwerte mit für einen ordnungsgemäßen Zustand zu erwartenden Werten.

So wird dann, wenn wenigstens einer der in dem ersten Prüfungsvorgang erhaltenen Messwerte für den Strom und/oder die Spannung einen gegenüber einem zuvor festgelegten Normalzustand um einen oberhalb einer vordefinierten Toleranzschwelle liegenden Wert erhöhten ersten Widerstand anzeigen und/oder wenn wenigstens einer der in dem zweiten Prüfungsvorgang erhaltenen Messwerte für den Strom und/oder die Spannung einen gegenüber einem zuvor festgelegten Normalzustand um einen um mehr als eine vordefinierte Toleranzschwelle verminderten zweiten Widerstand anzeigen, auf einen eine Betriebsbereitschaft verhindernden Fehler des elektrischen Systems des Drehstrommotors und/oder der Zuleitungen geschlossen.

Die beiden Prüfungsvorgängen können insbesondere mehrfach und sukzessive für unterschiedliche Paarungen der Zuleitungen durchgeführt werden.

Die für den Normalzustand zu erwartenden Messwerte können dabei aus bekannten elektrischen Kennwerten des Drehstrommotors, ggf. unter Berücksichtigung des Einflusses der Zuleitungen rechnerisch ermittelt werden. Sie können aber insbesondere auch empirisch festgelegt werden, indem unmittelbar nach der Installation des an die Steuerschaltung angeschlossenen Drehstrommotors zunächst ein Funktionstest durchgeführt und dann, nach Feststellen der Funktionsfähigkeit, der erste und der zweite Prüfungsvorgang jeweils durchgeführt werden und mit den dort an dem System aus Drehstrommotor und Zuleitungen ermittelten Messwerten jeweils der zugeordnete Normalzustand festgelegt wird.

Es soll an dieser Stelle betont werden, dass es für das erfindungsgemäße Verfahren nicht von Belang ist, ob die beiden Prüfungsvorgänge in einer bestimmten Reihenfolge durchgeführt werden. Insoweit sollen die Bezeichnungen "erster Prüfungsvorgang" und "zweiter Prüfungsvorgang" nicht etwa der Festlegung einer zeitlichen Reihenfolge dieser Schritte verstanden werden. Sie dienen vielmehr lediglich einer unterscheidenden Bezugnahme dieser unterschiedlichen Bestandteile des Verfahrens. Auch die Reihenfolge, in der diese beiden Prüfungsvorgänge im Anspruch 1 angeführt sind, ist nicht als eine chronologische Vorgabe gemeint. Wichtig ist allein, dass beide Prüfungsvorgänge zum Tragen kommen, um das Verfahren erfindungsgemäß durchzuführen. Dabei ist es auch nicht etwa bedeutsam, dass in einem Verfahrensdurchlauf beide Prüfungsvorgänge genau einmal oder auch nur in gleicher Zahl vorgenommen werden. Es kann durchaus im Rahmen der Erfindung vorgesehen sein, dass einer der beiden Prüfungsvorgänge mehrfach und der andere Prüfungsvorgang z.B. nur einmal oder jedenfalls in einer geringeren Zahl durchgeführt wird.

Mit dem erfindungsgemäßen Verfahren kann eine Überprüfung der Betriebsbereitschaft eines Drehstrommotors und insbesondere seiner elektrischen Anschlussleitungen insbesondere wiederholt durchgeführt werden, um so insbesondere eine Überwachung der Betriebsbereitschaft zu erhalten. Die Prüfungsvorgänge, erster Prüfungsvorgang und zweiter Prüfungsvorgang, werden dazu in vorbestimmten Zeitintervallen wiederholt durchgeführt. Durch eine Festlegung der Dauer der vorbestimmten Zeitintervalle kann eine Überwachungsintensität, bzw. -dichte bestimmt werden. Wird eine besonders enge zeitliche Abfolge der Zeitintervalle gewählt, so kann eine quasikontinuierliche Überwachung durchgeführt werden.

Mit dem vorstehend beschriebenen grundsätzlichen Überprüfungsverfahren können ganz allgemein Fehler in Form von Aderbrüchen und Kurzschlüssen zwischen einzelnen Adern einer dreiphasigen Drehstrommotorleitung allgemein erkannt werden. Es können bei der vorstehend beschriebenen Vorgehensweise allerdings nicht unbedingt verschiedene grundsätzlich mögliche Fehler genau unterschieden, es kann so noch keine spezifischere Fehleranalyse unternommen werden.

Im Rahmen des erfindungsgemäßen Verfahrens und Vorgehens ist, wenn eine spezifischere Auswertung der erkannten Widerstände unternommen wird, es aber auch möglich eine genauer eingegrenzte Fehlerbestimmung vorzunehmen.

Dabei sind auch nicht zwingend durch das einzelne Messen aller Adern jeweils mit angeschlossener Gleichstromquelle oder Wechselstromquelle mit niedriger Frequenz einerseits und mit angeschlossener Wechselstromquelle mit hoher Frequenz andererseits einzelne Messungen in großer Zahl erforderlich. Bei einem nachfolgend beschriebenen Vorgehen, bei dem die meisten Messungen gleichzeitig an den Zuleitungen L2 und L3 durchgeführt werden können, können aufgetretene Fehler genauer unterschieden werden. Dabei können dann auch weniger Einzelmessungen erforderlich sein.

### Tests auf Leitungsbrüche:

Mit dem hier offenbarten Verfahren kann auf ein Leitungsbruch der Zuleitung L1 oder von mehreren der Zuleitungen L1, L2 und L3 geschlossen werden, wenn bei einer gleichzeitigen Messung mit einmal einer zwischen der Zuleitung L2 und der Zuleitung L1 angeschlossenen Gleichstromquelle oder Wechselstromquelle mit niedriger Frequenz sowie ferner einer zwischen der Zuleitung L3 und der Zuleitung L1 angeschlossenen Gleichstromquelle oder Wechselstromquelle mit niedriger Frequenz die an den Zuleitungen L2 und L3 ermittelten Widerstände jeweils und beide eine zuvor festgelegte Schwelle, eine Störungsschwelle, überschreitet, also für beide Widerstände ein überhöhter Wert festgestellt wird.

Auf einen Leitungsbruch von L2 kann geschlossen werden, wenn bei einer gleichzeitigen Messung mit einmal einer zwischen der Zuleitung L2 und der Zuleitung L1 angeschlossenen Gleichstromquelle oder Wechselstromquelle mit niedriger Frequenz sowie ferner einer zwischen der Zuleitung L3 und der Zuleitung L1 angeschlossenen Gleichstromquelle oder Wechselstromquelle mit niedriger Frequenz allein der an der Zuleitung L2 gemessene Widerstand einen definierten Störungsschwelle überschreitet.

Auf einen Leitungsbruch von L3 kann geschlossen werden, wenn bei einer gleichzeitigen Messung mit einmal einer zwischen der Zuleitung L2 und der Zuleitung L1 angeschlossenen Gleichstromquelle oder Wechselstromquelle mit niedriger Frequenz sowie ferner einer zwischen der Zuleitung L3 und der Zuleitung L1 angeschlossenen Gleichstromquelle oder Wechselstromquelle mit niedriger Frequenz allein der an der Zuleitung L3 gemessene Widerstand einen definierten Störungsschwelle überschreitet.

### Tests auf Kurzschlüsse:

Mit dem hier offenbarten Verfahren kann auf einen Kurzschluss zwischen den Zuleitungen L1 und L2 geschlossen werden, wenn bei einer gleichzeitigen Messung mit einmal einer zwischen der Zuleitung L2 und der Zuleitung L1 angeschlossenen Wechselstromquelle mit hoher Frequenz sowie ferner mit einer zwischen der Zuleitung L3 und der Zuleitung L1 angeschlossenen Wechselstromquelle mit hoher Frequenz der an der Zuleitung L2 gemessene Widerstand einen definierten Schwellwert, eine Kurzschlussschwelle, unterschreitet, also ein besonders niedriger Widerstand ermittelt wird, und wenn dabei gleichzeitig der an der Zuleitung L3 gemessene Widerstand einen definierten Schwellwert, eine Intaktschwelle, überschreitet, hier also ein ausreichend hoher Widerstand bestimmt wird.

Auf einen Kurzschluss zwischen den Zuleitungen L1 und L3 kann geschlossen werden, wenn bei einer gleichzeitigen Messung mit einmal einer zwischen der Zuleitung L2 und der Zuleitung L1 angeschlossenen Wechselstromquelle mit hoher Frequenz sowie ferner mit einer zwischen der Zuleitung L3 und der Zuleitung L1 angeschlossenen Wechselstromquelle mit hoher Frequenz der an der Zuleitung L3 gemessene Widerstand eine definierte Kurzschlussschwelle unterschreitet und gleichzeitig der an der Zuleitung L2 gemessene Widerstand eine definierte Intaktschwelle überschreitet.

Auf einen Kurzschluss zwischen den Zuleitungen L2 und L3 kann dann geschlossen werden, wenn gleichzeitig folgende Bedingungen erfüllt sind:
- Bei einer gleichzeitigen Messung mit einmal einer zwischen der Zuleitung L2 und der Zuleitung L1 angeschlossenen Wechselstromquelle mit hoher Frequenz sowie ferner mit einer zwischen der Zuleitung L3 und der Zuleitung L1 angeschlossenen Wechselstromquelle mit hoher Frequenz überschreiten sowohl der an der Zuleitung L2 bestimmte Widerstand als auch der an der Zuleitung L3 bestimmte Widerstand jeweils eine definierte Intaktschwelle; es werden also für beide genannten Widerstände ausreichend hohe Widerstandswerte ermittelt, UND
- die Differenz der in den Zuleitungen L2 und L3 gemessenen Spannungen jeweils bei einzelner, also getrennter Messung mit zum einen einer zwischen der Zuleitung L2 und der Zuleitung L1 angeschlossenen Wechselstromquelle mit hoher Frequenz und mit zum anderen einer zwischen der Zuleitung L3 und der Zuleitung L1 angeschlossenen Wechselstromquelle mit hoher Frequenz unter einer vorbestimmten Schwelle, einer Differenzschwelle, liegen.

Auf einen Kurzschluss zwischen den Zuleitungen L1, L2 und L3 kann geschlossen werden, wenn bei einer gleichzeitigen Messung mit einmal einer zwischen der Zuleitung L2 und der Zuleitung L1 angeschlossenen Wechselstromquelle mit hoher Frequenz sowie ferner mit einer zwischen der Zuleitung L3 und der Zuleitung L1 angeschlossenen Wechselstromquelle mit hoher Frequenz die an den Zuleitungen L2 und L3 bestimmten Widerstände jeweils unter einer definierte Kurzschlussschwelle liegen.

Ein weiterer Aspekt der Erfindung liegt in einer Steuerschaltung für die Steuerung eines daran angeschlossenen Drehstrommotors, welche Steuerschaltung für die Durchführung eines wie vorstehend beschriebenen Verfahrens eingerichtet ist. Insbesondere umfasst die Steuerschaltung dabei dann die für die beiden Prüfungsvorgänge erforderlichen Stromquellen, also die erste und die zweite Stromquelle, über Schalteinrichtungen zum Verbinden von verschiedenen Paaren der Zuleitungen L1, L2 und L3 mit der jeweils verschalteten Stromquelle jeweils zu einem Stromkreis und über entsprechende Messsensorik zum Messen von Stromstärke und/oder Spannung in dem jeweils geschalteten Stromkreis.

Eine weitere Ausprägung der Erfindung besteht in einer Entrauchungseinrichtung für ein Gebäude mit wenigstens einem Luftförderer, der einen Drehstrommotor zum Antreiben eines Luftförderelements aufweist, wobei der Drehstrommotor an eine eine Steuerschaltung, wie vorstehend genannt, umfassende Steuerung angeschlossen ist, über die in einem Bedarfsfall der Luftförderer zum Betreiben des Luftförderelements beschaltet wird.

Noch eine weitere Ausprägung der Erfindung besteht in einer mit einem motorisch antreibbaren Verschlusselement versehenen Gebäudeöffnung, wie insbesondere einer Lüftungsklappe oder einem Fenster, bei der ein Klappenelement der Lüftungsklappe oder ein Fensterflügel des Fensters mittels eines Drehstrommotors zum Öffnen und/oder Schließen der Gebäudeöffnung verlagerbar ist und wobei der Drehstrommotor an eine eine Steuerschaltung, wie vorstehend genannt, umfassende Steuerung angeschlossen ist, über die in einem Bedarfsfall der Drehstrommotor zum Öffnen oder Schließen der Gebäudeöffnung beschaltet wird.

Weitere Vorteile und Merkmale der Erfindung ergeben sich aus der nachfolgenden Beschreibung einer möglichen Ausführungsform der Erfindung, bei der auch auf die beigefügte Figur Bezug genommen wird. Es zeigt:

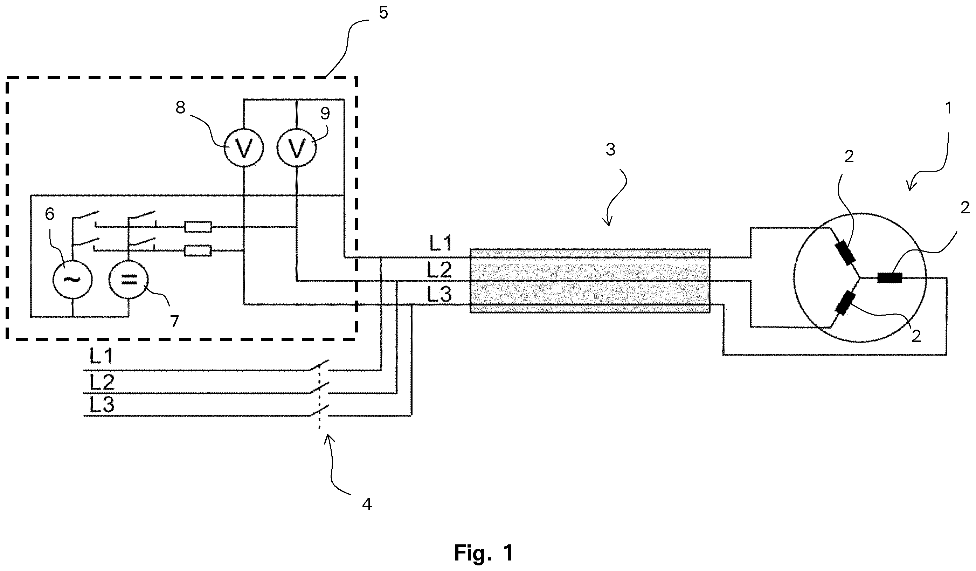

- Fig. 1: eine schematische Darstellung einer elektrischen Verschaltung eines über elektrische Anschlussleitungen an eine Steuerung angeschlossenen Drehstrommotors mit einer Schaltung zur Durchführung eines erfindungsgemäßen Verfahrens.

In Fig. 1 ist eine Verschaltung eines Drehstrommotors 1 veranschaulicht mit einer eingebundenen Schaltung für die Überprüfung der Betriebsbereitschaft des nicht betriebenen, also zwar angeschlossenen, aber stillstehenden Motors 1 und der elektrischen Zuleitung, bzw. Anschussleitung. In der Figur sind mit 2 die Statorwicklungen des Drehstrommotors 1 symbolisiert, die - hier in einer Sternschaltung - mit jeweils einem der in einem dreiphasigen Zuleitungskabel 3 geführten Phasenleiter L1, L2 und L3 verbunden sind. Über einen mit 4 veranschaulichten Schalter, der über eine nicht näher dargestellte Steuerung angesteuert betätigbar ist, können die Phasenleiter L1, L2 und L3 mit einem entsprechenden Drehstrom beaufschlagt werden.

Ebenfalls, in der Darstellung ohne einen zwischengeordneten Schalter, mit den Phasenleitern L1, L2 und L3 verbunden sind die Ausgänge einer Überprüfungsschaltung 5. Diese Überprüfungsschaltung 5 kann insbesondere ebenfalls mit der hier nicht gezeigten Steuerung verbunden sein, um die Funktion der Überprüfungsschaltung 5 zu steuern und gezielt Überprüfungsvorgänge auslösen und Messergebnisse oder Auswertungssignale von der Überprüfungsschaltung 5 empfangen und weiterverarbeiten zu können. In der Überprüfungsschaltung 5 sind zwei Stromquellen, eine Wechselstromquelle 6 und eine Gleichstromquelle 7, integriert, die jeweils mit einem ersten Ausgang fest mit dem Phasenleiter L1 verbunden sind und die mit einem zweiten Ausgang jeweils wahlweise mit dem Phasenleiter L2 oder L3 verbunden werden können, wobei immer nur eine der beiden Stromquellen, Wechselstromquelle 6 oder Gleichstromquelle 7, auf einen der Phasenleiter L2 oder L3 aufgeschaltet werden kann. Spannungsmesser 8 und 9 sind zwischen L1 und L3 (Spannungsmesser 8), bzw. L1 und L2 (Spannungsmesser 9) und jeweils parallel zu den Stromquellen 6, bzw. 7 geschaltet.

Wenngleich die in Fig. 1 veranschaulichte Schaltung keinen elektrischen Schalter für eine galvanische Trennung der Überprüfungsschaltung 5 von den dort angeschlossenen Verbindungen zu den Phasenleitern L1, L2 und L3 aufzeigt, kann ein solcher Schalter vorhanden sein, um insbesondere dann, wenn über den Schalter 4 der zum Betreiben des Drehstrommotors 1 benötigte Drehstrom auf die Phasenleiter L1, L2 und L3 gegeben wird, die Überprüfungsschaltung 5 vor möglichen Schäden durch die angelegte Spannung bzw. den angelegten Drehstrom zu bewahren. Insbesondere sind die von den Stromquellen 6 bzw. 7 erzeugten Spannungen und Ströme typischerweise wesentlich geringer als die für den Betrieb des Drehstrommotors 1 angelegte Spannung und der in den Phasenleitern L1, L2 und L3 fließende Strom. Denn die von den Stromquellen 6 und 7 erzeugten Spannungen bzw. die aufgrund der Ausgabe dieser Stromquellen 6 und 7 fließenden Ströme dienen lediglich für die Erzeugung von Messsignalen, sollen den Drehstrommotor 1 gerade nicht in Betrieb, also in Bewegung, setzen.

Als eine mögliche Ausführungsform der Erfindung wird nachfolgend eine Überprüfung oder auch Überwachung eines Drehstrommotors 1 zusammen mit dem von einer Steuereinrichtung zu dem Drehstrommotoren 1 führenden dreiphasigen Zuleitungskabel 3 beschrieben, wobei es sich bei dem Drehstrommotor 1 insbesondere um einen solchen handeln kann, der in einem Brandgas- oder Zuluftventilator für die maschinelle Entrauchung bzw. Überdruckbelüftung oder in einem natürlichen Rauch- und Wärmeabzugsgerät integriert ist, aber auch um einen in einer anderen Einheit, wie z.B. in einem Klappen- oder einem Fensterantrieb, integrierten Drehstrommotor 1 . Die Überprüfung bzw. ggf. auch Überwachung wird dabei während des Bereitschaftsbetriebs, also gerade dann, wenn der Drehstrommotor 1 nicht betrieben wird, durchgeführt.

Die drei Phasenleiter L1, L2, L3 des zu dem Drehstrommotor 1 führenden Zuleitungskabels 3 sind mit der Steuerung verbunden und über den Schalter 4 mit einer Drehstromversorgung beaufschlagbar zum Betreiben des Drehstrommotors 1. Die Phasenleiter L1, L2, L3 verbinden mit einem Abzweig zudem die Überprüfungsschaltung 5 im Bereitschaftsbetrieb direkt mit den Statorwicklungen 2 des Drehstrommotors 1. Die Überprüfungsschaltung 5 ist in der Anordnung vorzugsweise nahe bei der Steuerung platziert oder stellt einen Bestandteil der Steuerung dar.

Bei einer Überprüfung der Betriebsbereitschaft des Drehstrommotors 1 im nicht betriebenen Zustand wird in der Überprüfungsschaltung 5 durch eine Messung der durch ein Einspeisen des mit der Wechselstromquelle bzw. der Gleichstromquelle erzeugten Stroms in jeweils ein Paar der Phasenleiter L1, L2 bzw. L1, L3, und Bewertung der anhand der ermittelten Spannungswerte rückgeschlossenen Impedanzen der jeweils in dem Stromkreis gepaarten Phasenleiter L1, L2 bzw. L1, L3 der Zustand der elektrischen Verbindung einschließlich des Zuleitungskabels 3 mit den Phasenleitern L1, L2, L3 und der Statorwicklungen 2 auf eine gegebene Funktionsbereitschaft hin überprüft. Diese Prüfung wird in zwei Prüfungsvorgängen unternommen, nämlich

### Prüfung auf einen etwaigen Drahtbruch:

Zur Erkennung eines Drahtbruchs, z.B. eines der Phasenleiter L1, L2, L3 in dem Zuleitungskabel 3, wird von der Überprüfungsschaltung 5, insbesondere getriggert durch die Steuerung, jeweils über eines der verschaltbaren Paare der Phasenleiter L1, L2 und L1, L3 auf die Statorwicklungen 2 des Drehstrommotors 1 ein mit der Gleichstromquelle 7 erzeugter Gleichstrom gegeben. Dabei wird die an der Steuerungsseite des jeweiligen Paares der Phasenleiter L1, L2 und L1, L3 anliegende Spannung mit dem zugordneten Spannungsmesser 8, 9 gemessen. Basierend auf der gemessenen Spannung kann auf den Gesamtwiderstand von Zuleitungskabel 3 (jeweils in den Paarungen L1, L2 bzw. L1, L3) und den involvierten Statorwicklungen 2 geschlossen werden. Ist der von der Gleichstromquelle ausgebebene Strom bekannt, so kann der Gesamtwiderstand auch rechnerisch bestimmt werden. Alternativ zu Gleichstrom kann auch ein mit einer anstelle der Gleichstromquelle 7 eingesetzten Wechselstromquelle erzeugter Wechselstrom mit niedriger Frequenz verwendet werden. Wenn die Wechselstromquelle 6 eine solche mit einstellbarer Frequenz des Wechselstroms ist, kann auch diese verwendet werden. Unter einem Wechselstrom niedriger Frequenz ist ein Wechselstrom zu verstehen, dessen Frequenz so niedrig gewählt ist, dass die Induktivität der Statorwicklung 2 des Drehstrommotors 1 in dem jeweils geschalteten Stromkreis für einen Wechselstrom dieser Frequenz keinen wesentlichen Blindwiderstand aufweist, insbesondere einen Blindwiderstand, der um wenigstens eine Größenordnung niedriger liegt als der gesamte Leitungswiderstand der des Zuleitungskabels 3, genauer der jeweils verschalteten Phasenleiter L1, L2 oder L1, L3 sowie der weiteren internen Leitungen in dem Drehstrommotor 1.

Bei Gleichstrom oder Wechselstrom mit niedriger Frequenz wird der Leitungswiderstand und der - größenmäßig geringe - Gleichstromwiderstand der Statorwicklungen 2 wirksam. Liegt eine Unterbrechung einer Ader der elektrischen Leitungen, also eines der Phasenleiter L1, L2, L3 in dem Zuleitungskabel 3 oder auch eine interne Leitung in dem Drehstrommotor 1, vor, so erhöht sich der in diesem Prüfungsvorgang bewertete Widerstand gegenüber einem für einen Normalzustand ermittelten Widerstand und dies wird als Drahtbruch gewertet.

### Prüfung auf einen etwaigen Kurzschluss:

Zur Erkennung von Kurzschlüssen zwischen den mit den Phasenleitern L1, L2, bzw. L3 verbundenen Adern von Leitungen wird von der Überprüfungsschaltung 5, insbesondere angesteuert durch die Steuerung, jeweils über die auf die Phasenleiter L1, L2, L3 gelegten Zuleitungen und weiter über die Phasenleiter L1, L2, L3 auf die Statorwicklungen 2 des Drehstrommotors 1 in einer wiederum paarweisen Verschaltung jeweils ein Wechselstrom mit einer höheren Frequenz gegeben. Die Frequenz wird dabei so hoch gewählt, dass der Blindwiderstand der Induktivität der Statorwicklung 2 wesentlich höher ist als der Widerstand der zu überwachenden Zuleitung. Liegt kein Kurzschluss zwischen den Phasenleitern L1, L2, L3 der Zuleitung vor, wird der relativ hohe Blindwiderstand der in dem jeweiligen Stromkreis verschalteten Statorwicklungen 2 gemessen.

Liegt jedoch zwischen den Phasenleitern L1, L2 und/oder L3 der Leitung ein Kurzschluss vor, wird der gemessene Wert von dem durch den Kurzschluss bedingten geringen Leitungswiderstand bestimmt und wird ein geringer Leitungswiderstand, der um einen eine Toleranzschwelle unterhalb eines für einen Normalzustand ermittelten Widerstandes liegt, als Kurzschluss gewertet.

Neben der vorstehend beschriebenen allgemein gehaltenen Bestimmungen eines - irgendwo aufgetretenen - Drahtbruchs, bzw. eines - irgendwo aufgetretenen - Kurzschlusses, können mit einem nachfolgend beschriebenen Vorgehen auch genauere Analysen unternommen werden:

### Prüfung auf etwaige Drahtbrüche und Bestimmung der unterbrochenen Leitung:

Es wird gleichzeitig jeweils zwischen L2 und L1 und auch zwischen L3 und L1 eine Gleichstromquelle oder eine Wechselstromquelle mit niedriger Frequenz angeschlossenen. Dann wird in den jeweils so gebildeten Stromkreisen der an den Zuleitungen L2 anliegende Widerstand und es wird der an der Zuleitung L3 anliegende Widerstand ermittelt, insbesondere durch eine Spannungsmessung mit den Spannungsmessern 8 und 9.

Wird bei einem solchen Vorgehen nun festgestellt, dass sowohl der Widerstand an L2 als auch der Widerstand an L3 jeweils eine zuvor festgelegte Schwelle, eine Störungsschwelle, überschreitet, wird also für beide Zuleitungen ein überhöhter Widerstand festgestellt, dann ist auf ein Leitungsbruch der Zuleitung L1 oder von mehreren der Zuleitungen L1, L2 und L3 zu schließen.

Wird hingegen erkannt, dass allein der an der Zuleitung L2 gemessene Widerstand eine definierte Störungsschwelle überschreitet, so ist auf einen Leitungsbruch von L2 zu schließen.

Wird allein für L3 ein eine definierte Störungsschwelle überschreitender Widerstand erkannt, so ist auf einen Leitungsbruch von L3 zu schließen.

### Prüfung auf etwaige Kurzschlüsse und Bestimmung der kurzgeschlossenen Leitungen:

Es werden zunächst gleichzeitig jeweils zwischen L2 und L1 und auch zwischen L3 und L1 eine Wechselstromquelle mit hoher Frequenz angeschlossenen. Dann wird in den jeweils so gebildeten Stromkreisen der an L2 anliegende Widerstand und es wird der an L3 anliegende Widerstand ermittelt, insbesondere durch eine Spannungsmessung mit den Spannungsmessern 8 und 9.

Wenn bei dieser gleichzeitigen Messung der an L2 gemessene Widerstand einen definierten Schwellwert, eine Kurzschlussschwelle, unterschreitet, also ein besonders niedriger Widerstand ermittelt wird, und wenn dabei gleichzeitig der an L3 gemessene Widerstand einen definierten Schwellwert, eine Intaktschwelle, überschreitet, hier also ein ausreichend hoher Widerstand bestimmt wird, ist auf einen Kurzschluss zwischen L1 und L2 zu schließen.

Auf einen Kurzschluss zwischen L1 und L3 ist zu schließen, wenn bei dieser gleichzeitigen Messung der an L3 gemessene Widerstand eine definierte Kurzschlussschwelle unterschreitet und gleichzeitig der an L2 gemessene Widerstand eine definierte Intaktschwelle überschreitet.

Auf einen Kurzschluss zwischen L1, L2 und L3 ist zu schließen, wenn bei dieser gleichzeitigen Messung die an L2 und L3 bestimmten Widerstände jeweils beide unter einer definierte Kurzschlussschwelle liegen.

Um einen möglichen Kurzschluss zwischen L2 und L3 schließen zu können sind verschiedene Messungen erforderlich, wobei auf einen solchen Kurzschluss zu schließen ist, wenn gleichzeitig folgende Bedingungen erfüllt sind:
- Bei einer gleichzeitigen Messung mit einmal einer zwischen L2 und L1 angeschlossenen Wechselstromquelle mit hoher Frequenz sowie ferner mit einer zwischen L3 und L1 angeschlossenen Wechselstromquelle mit hoher Frequenz überschreiten sowohl der an L2 bestimmte Widerstand als auch der an L3 bestimmte Widerstand jeweils eine definierte Intaktschwelle; es werden also für beide genannten Widerstände ausreichend hohe Widerstandswerte ermittelt, UND
- die Differenz der in L2 und L3 gemessenen Spannungen jeweils bei einzelner, also getrennter Messung mit zum einen einer zwischen der Zuleitung L2 und der Zuleitung L1 angeschlossenen Wechselstromquelle mit hoher Frequenz und mit zum anderen einer zwischen der Zuleitung L3 und der Zuleitung L1 angeschlossenen Wechselstromquelle mit hoher Frequenz liegen unter einer vorbestimmten Schwelle, einer Differenzschwelle.

Wenn die vorstehend beschriebenen Überprüfungen innerhalb von ausreichend kurzen Abständen wiederkehrend ausgeführt werden, wird eine Überwachung der Betriebsbereitschaft des Drehstrommotors 1 und insbesondere auch des diesen anschließenden Anschlusskabels 3 im nicht betriebenen Zustand erhalten. Dies kann, bei entsprechend kurzer Taktung, auch quasikontinuierlich erfolgen.

Es ist im Rahmen der Erfindung auch möglich, die vorstehend geschilderte Überprüfung oder Überwachung mit an sich gängigen und bekannten Verfahren zum Überprüfen oder Überwachen des Zustandes und der Funktion des Drehstrommotors 1 im laufende Zustand, z.B. durch Auswertung von Störmeldungen von z.B. Phasenüberwachungsrelais, Motorschutzschaltern, Softstartern, Frequenzumrichtern oder von anderen Motorüberwachungseinrichtungen, zu kombinieren und so die Möglichkeiten einer Überprüfung bzw. Überwachung zu erweitern. Eine solche Kombination ist im Rahmen der Erfindung zwar möglich, nicht jedoch erforderlich.

### Bezugszeichenliste

- 1: Drehstrommotor
- 2: Statorwicklung
- 3: dreiphasiges Zuleitungskabel
- 4: Schalter
- 5: Überprüfungsschaltung
- 6: Wechselstromquelle
- 7: Gleichstromquelle
- 8: Spannungsmesser
- 9: Spannungsmesser

## Patentansprüche

1. Verfahren zum Überwachen der Betriebsbereitschaft eines an eine Steuerschaltung angeschlossenen Drehstrommotors (1) nebst der diesen Drehstrommotor (1) mit der Steuerschaltung verbindenden, dreiphasigen Zuleitungen (L1, L2, L3) in einem nicht betriebenen Zustand, **gekennzeichnet dadurch, dass**
a. für eine Prüfung hinsichtlich eines möglichen Kabelbruchs eine erste Stromquelle (7) in Form einer Gleichstromquelle oder einer Wechselstromquelle niedriger Frequenz mit wenigstens jeweils zwei unterschiedlichen Paaren der Zuleitungen (L1, L2, L3) zeitgleich oder nacheinander verbunden wird und als Indikator für einen ersten elektrischen Widerstand ein Strom und/oder eine Spannung in dem so geschalteten Stromkreis gemessen wird und
b. für eine Prüfung hinsichtlich eines möglichen Kurzschlusses eine zweite Stromquelle (6) in Form einer Wechselstromquelle hoher Frequenz mit wenigstens jeweils zwei unterschiedlichen Paaren der Zuleitungen (L1, L2, L3) zeitgleich oder nacheinander verbunden wird und als Indikator für einen zweiten elektrischen Widerstand ein Strom und/oder eine Spannung in dem so geschalteten Stromkreis gemessen wird, wobei die Frequenz der zweiten Spannung so groß gewählt wird, dass ein Blindwiderstand der Induktivität der Statorwicklung (2) des Drehstrommotors (1) in dem geschalteten Stromkreis wesentlich höher ist als der Widerstand der zu überwachenden Zuleitung,
wobei dann, wenn wenigstens einer der unter a. erhaltenen Messwerte für den Strom und/oder die Spannung einen gegenüber einem zuvor festgelegten Normalzustand um einen über eine vordefinierten Toleranzschwelle liegenden Wert erhöhten ersten Widerstand anzeigen und/oder wenn wenigstens einer der unter b. erhaltenen Messwerte für den Strom und/oder die Spannung einen gegenüber einem zuvor festgelegten Normalzustand um einen über einer vordefinierten Toleranzschwelle liegenden Wert verminderten zweiten Widerstand anzeigen, auf einen eine Betriebsbereitschaft verhindernden Fehler des elektrischen Systems des Drehstrommotors (1) und/oder der Zuleitungen (L1, L2, L3) geschlossen wird.

2. Verfahren nach Anspruch 1, **dadurch gekennzeichnet, dass** die Prüfschritte a. und b. mehrfach und sukzessive für unterschiedliche Paarungen der Zuleitungen (L1, L2, L3) durchgeführt werden.

3. Verfahren nach einem der vorhergehenden Ansprüche, **dadurch gekennzeichnet, dass** für eine Festlegung des jeweiligen Normalzustandes unmittelbar nach der Installation des an die Steuerschaltung angeschlossenen Drehstrommotors (1) zunächst ein Funktionstest durchgeführt und dann, nach Feststellen der Funktionsfähigkeit, die Prüfschritte a. und b. durchgeführt und mit den dort ermittelten Messwerten jeweils der Normalzustand festgelegt wird.

4. Verfahren nach einem der vorhergehenden Ansprüche, **dadurch gekennzeichnet, dass** die Prüfschritte a. und b. in vorbestimmten Zeitintervallen wiederholt durchgeführt werden.

5. Verfahren nach Anspruch 4, **dadurch gekennzeichnet, dass** durch eine enge zeitliche Abfolge der Zeitintervalle eine quasikontinuierliche Überwachung durchgeführt wird.

6. Steuerschaltung für die Steuerung eines daran angeschlossenen Drehstrommotors, **dadurch gekennzeichnet, dass** sie für die Durchführung eines Verfahrens nach einem der vorhergehenden Ansprüche eingerichtet ist.

7. Entrauchungseinrichtung für ein Gebäude mit wenigstens einem Luftförderer, wobei der Luftförderer einen Drehstrommotor (1) zum Antrieb eines Luftförderelements aufweist und wobei der Drehstrommotor (1) an eine Steuerung angeschlossen ist, über die in einem Bedarfsfall der Luftförderer zum Betreiben des Luftförderelements beschaltet wird, **dadurch gekennzeichnet, dass** die Steuerung eine Steuerschaltung nach Anspruch 6 aufweist.

8. Mit einem motorisch antreibbaren Verschlusselement versehene Gebäudeöffnung, wie insbesondere eine Lüftungsklappe oder ein Fenster, wobei ein Klappenelement der Lüftungsklappe oder ein Fensterflügel des Fensters mittels eines Drehstrommotors (1) zum Öffnen und/oder Schließen der Gebäudeöffnung verlagerbar ist und wobei der Drehstrommotor (1) an eine Steuerung angeschlossen ist, über die in einem Bedarfsfall der Drehstrommotor zum Öffnen oder Schließen der Gebäudeöffnung beschaltet wird, **dadurch gekennzeichnet, dass** die Steuerung eine Steuerschaltung nach Anspruch 6 aufweist.

## Claims

1. Method for monitoring the operational readiness of a three-phase motor (1) connected to a control circuit, together with the three-phase supply lines (L1, L2, L3) connecting this three-phase motor (1) to the control circuit, in a non-operational state, **characterised in that**
a. for testing for a possible cable break, a first current source (7) in the form of a direct current source or a low-frequency alternating current source is connected to at least two different pairs of the supply lines (L1, L2, L3) simultaneously or successively, and a current and/or a voltage in the circuit connected in this way is measured as an indicator of a first electrical resistance, and
b. for testing for a possible short circuit, a second current source (6) in the form of a high-frequency alternating current source is connected to at least two different pairs of the supply lines (L1, L2, L3) simultaneously or sequentially, and a current and/or voltage in the circuit thus connected is measured as an indicator of a second electrical resistance, the frequency of the second voltage being selected to be so high that a reactive resistance of the inductance of the stator winding (2) of the three-phase motor (1) in the connected circuit is significantly higher than the resistance of the supply line to be monitored,
whereby, if at least one of the measured values obtained under a. for the current and/or the voltage indicates a first resistance that is increased by a value exceeding a predefined tolerance threshold compared to a previously defined normal state and/or if at least one of the measured values obtained under b. for the current and/or voltage indicates a second resistance that is reduced by a value exceeding a predefined tolerance threshold compared to a previously defined normal state, it is concluded that there is a fault in the electrical system of the three-phase motor (1) and/or the supply lines (L1, L2, L3) that prevents it from being ready for operation.

2. Method according to claim 1, **characterised in that** test steps a. and b. are carried out multiple times and successively for different pairings of the supply lines (L1, L2, L3).

3. Method according to one of the preceding claims, **characterised in that**, in order to determine the respective normal state immediately after installation of the three-phase motor (1) connected to the control circuit, a function test is first carried out and then, after determining the functionality, test steps a. and b. are carried out and the normal state is determined in each case using the measured values determined there.

4. Method according to one of the preceding claims, **characterised in that** test steps a. and b. are repeated at predetermined time intervals.

5. Method according to claim 4, **characterised in that** quasi-continuous monitoring is performed by means of a close temporal sequence of the time intervals.

6. Control circuit for controlling a three-phase motor connected thereto, **characterised in that** it is designed to carry out a method according to one of the preceding claims.

7. Smoke extraction device for a building with at least one air conveyor, wherein the air conveyor has a three-phase motor (1) for driving an air conveyor element and wherein the three-phase motor (1) is connected to a control system via which, in case of need, the air conveyor is activated to operate the air conveyor element, **characterised in that** the control unit has a control circuit according to claim 6.

8. Building opening equipped with a motor-driven closure element, such as in particular a ventilation flap or a window, wherein a flap element of the ventilation flap or a window sash of the window can be moved by means of a three-phase motor (1) for opening and/or closing the building opening, and wherein the three-phase motor (1) is connected to a control system via which, when required, the three-phase motor is activated to open or close the building opening, **characterised in that** the control system has a control circuit according to claim 6.

## Revendications

1. Procédé pour surveiller l'état de fonctionnement d'un moteur triphasé (1) connecté à un circuit de commande, ainsi que les lignes d'alimentation triphasées (L1, L2, L3) reliant ce moteur triphasé (1) au circuit de commande, dans un état non opérationnel, **caractérisé en ce que**
a. pour tester une éventuelle rupture de câble, une première source de courant (7) sous la forme d'une source de courant continu ou d'une source de courant alternatif à basse fréquence est connectée à au moins deux paires différentes des lignes d'alimentation (L1, L2, L3) simultanément ou successivement, et un courant et/ou une tension dans le circuit ainsi connecté sont mesurés comme indicateurs d'une première résistance électrique, et
b. pour tester un éventuel court-circuit, une seconde source de courant (6) sous la forme d'une source de courant alternatif à haute fréquence est connectée à au moins deux paires différentes des lignes d'alimentation (L1, L2, L3), et un courant et/ou une tension dans le circuit ainsi connecté sont mesurés indicateur d'une seconde résistance électrique, la fréquence de la seconde tension étant choisie de manière à être suffisamment élevée pour qu'une résistance réactive de l'inductance de l'enroulement statorique (2) du moteur triphasé (1) dans le circuit connecté soit nettement supérieure à la résistance de la ligne d'alimentation à surveiller,
de sorte que, si au moins l'une des valeurs mesurées obtenues sous a. pour le courant et/ou la tension indique une première résistance qui est augmentée d'une valeur dépassant un seuil de tolérance prédéfini par rapport à un état normal préalablement défini et/ou si au moins l'une des valeurs mesurées obtenues sous b. pour le courant et/ou la tension indique une seconde résistance qui est réduite d'une valeur dépassant un seuil de tolérance prédéfini par rapport à un état normal préalablement défini, il est conclu qu'il existe un défaut dans le système électrique du moteur triphasé (1) et/ou des lignes d'alimentation (L1, L2, L3) qui l'empêche d'être prêt à fonctionner.

2. Procédé selon la revendication 1, **caractérisé en ce que** les étapes de test a. et b. sont effectuées plusieurs fois et successivement pour différents appariements des lignes d'alimentation (L1, L2, L3).

3. Procédé selon l'une des revendications précédentes, **caractérisé en ce que**, afin de déterminer l'état normal respectif immédiatement après l'installation du moteur triphasé (1) connecté au circuit de commande, un test de fonctionnement est d'abord effectué, puis, après avoir déterminé la fonctionnalité, les étapes de test a. et b. sont effectuées et l'état normal est déterminé dans chaque cas à l'aide des valeurs mesurées qui y sont déterminées.

4. Procédé selon l'une des revendications précédentes, **caractérisé en ce que** les étapes de test a. et b. sont répétées à des intervalles de temps prédéterminés.

5. Procédé selon la revendication 4, **caractérisé en ce qu'**une surveillance quasi continue est effectuée au moyen d'une séquence temporelle rapprochée des intervalles de temps.

6. Circuit de commande pour commander un moteur triphasé qui y est connecté, **caractérisé en ce qu'**il est conçu pour exécuter un procédé selon l'une des revendications précédentes.

7. Dispositif d'extraction de fumée pour un bâtiment avec au moins un convoyeur d'air, dans lequel le convoyeur d'air comporte un moteur triphasé (1) pour entraîner un élément de convoyeur d'air et dans lequel le moteur triphasé (1) est relié à un système de commande par l'intermédiaire duquel, en cas de besoin, le convoyeur d'air est activé pour faire fonctionner l'élément de convoyeur d'air, **caractérisé en ce que** l'unité de commande comporte un circuit de commande selon la revendication 6.

8. Ouverture de bâtiment équipée d'un élément de fermeture motorisé, tel qu'en particulier un volet de ventilation ou une fenêtre, dans lequel un élément de volet du volet de ventilation ou un battant de fenêtre de la fenêtre peut être déplacé au moyen d'un moteur triphasé (1) pour ouvrir et/ou fermer l'ouverture du bâtiment, et dans lequel le moteur triphasé (1) est relié à un système de commande par l'intermédiaire duquel, en cas de besoin, le moteur triphasé est activé pour ouvrir ou fermer l'ouverture du bâtiment, **caractérisé en ce que** le système de commande comporte un circuit de commande selon la revendication 6.
